# EUROPEAN PATENT APPLICATION

(11) **EP 4 417 723 A1**
(43) Date of publication of application: **21.08.2024**
(21) Application number: 22898686.5
(22) Date of filing: 28.11.2022
(51) Int. Cl.: C22C 9/00, C25C 1/12

(54) **EASILY CRUSHABLE ELECTRODEPOSITED COPPER**

(30) Priority: 29.11.2021 JP 2021193500
(71) Applicant: JX Metals Corporation, Tokyo 105-8417 (JP)
(72) Inventor: FUKUNARI, Ayaka, Kitaibaraki-shi, Ibaraki 3191535 (JP); HOSOKAWA, Yu, Kitaibaraki-shi, Ibaraki 3191535 (JP)
(74) Representative: Mewburn Ellis LLP
(86) International application number: PCT/JP2022/043743
(87) International publication number: WO 2023/095904

(57) **Abstract**

A highly pure electrodeposited copper comprising copper and unavoidable impurities, wherein the purity is at least 6N, the content of Ag included as an impurity is 0.2 ppm or less, the amount of included nonmetal inclusions with a particle size of 0.5-20 um is 20,000/g or less, the average particle size in an electrodeposition cross section is in the range of 40-400 um, the maximum particle size in the electrodeposition cross section is in the range of 300-2,700 um, the average particle size in the electrodeposition surface is in the range of 25-150 um, and the maximum particle size in the electrodeposition surface is in the range of 100-450 um. As a result, the present invention provides a highly pure electrodeposited copper that has excellent crushability while suppressing the occurrence of lumps. (Selected drawing) FIG. 1B

## Description

### [Technical Field]

The present invention relates to an easily crushable electrodeposited copper.

### [Background Art]

Demand for high-purity copper as a raw material for Cu-based targets used in semiconductor production is increasing year by year. The high-purity copper, which is a raw material for Cu-based targets, is required not only to have high purity but also to be free from minute inclusions called particles, that is, to be so-called particle-free. In the production of the high-purity copper, a process of copper electrodeposition is always required. Therefore, the demand for production techniques for the electrodeposited copper is increasing year by year.

If the current density is increased to improve productivity of electrodeposited copper, many protrusions called bumps will be generated on a surface of the electrodeposited copper. The generation and growth of those bumps is undesirable in electrodeposition because the formation of an electric field becomes non-uniform and an unexpected electrical short circuit may occur. Therefore, to prevent the formation of bumps, organic additives are used to smooth the surface of the electrodeposited copper.

Further, the resulting electrodeposited copper is then subjected to processing such as crushing and melting, and then formed into an ingot that will become a raw material for Cu-based targets.

Patent Literature 1 describes high-purity copper in which the number of nonmetallic inclusions with a grain size of 0.5 um or more and 20 um or less is reduced to 10,000 per gram or less. Patent Literature 1 discloses that the high-purity copper was obtained by further melting electrolytic copper.

Patent Literature 2 describes high-purity electrolytic copper with a specific crystallite size and orientation index. Patent Literature 2 discloses that the high-purity electrolytic copper is obtained by adding an additive composed of a mixture of polyethylene glycol and polyvinyl alcohol (PVA) to an electrolyte and electrolyzing it at a current density that satisfies specific conditions.

Patent Literature 3 describes a method for producing electrolytic copper with low silver grade, using a sulfuric acid-based electrolyte containing hydrochloric acid. Patent Literature 3 discloses that silver ions are removed by adding hydrobromic acid to the electrolyte. However, no organic additive for smoothing is added to the electrolyte, and there is a high possibility that the electrodeposited copper of Patent Literature 3 has many lumps generated.

Patent Literature 4 describes a method for producing high-purity copper in which a nitrite gas is not generated on a surface of electrodeposited copper during electrolytic refining in a copper nitrate solution. Patent Literature 4 discloses that the generation of nitrite gas bubbles is suppressed by adding a predetermined amount of halide acid to the electrolyte. However, no organic additive for smoothing is added to the electrolyte, and there is a high possibility that the electrodeposited copper of Patent Literature 4 has many bumps generated.

### [Citation List]

### [Patent Literature]

[PTL 1]
   Japanese Patent No. 4620185 B
[PTL 2]
   Japanese Patent No. 6714909 B
[PTL3]
   Japanese Patent No. 5010535 B
[PTL 4]
   Japanese Patent No. 3102177 B

### [Summary of Invention]

### [Technical Problem]

The use of the organic additive is extremely effective in terms of suppression of the formation of lumps in electrodeposited copper. The suppression of the formation of lumps in electrodeposited copper is extremely valuable in terms of stable operation.

On the other hand, according to studies conducted by the present inventors, they have found that when the organic additive is added to the electrolyte in the production of electrodeposited copper, the strength of the resulting electrodeposited copper increases and the crushability deteriorates.

In general, the resulting electrodeposited copper is then subjected to crushing and melting processes and then formed into an ingot that will become a raw material for Cu-based targets. Therefore, deterioration of crushability decreases productivity. In addition, if the crushability is deteriorated, metal crushing equipment must be used for crushing, so that a possibility of contamination with impurities will be increased and a risk of particle generation will be increased. In other words, even if electrodeposited copper has excellent characteristics immediately after being obtained, the electrodeposited copper with poor crushability may lose its excellent characteristics during the crushing process before it becomes the raw material for the Cu-based targets.

Therefore, an object of the present invention is to provide high-purity electrodeposited copper that suppresses the generation of lumps and has improved crushability.

### [Solution to Problem]

As a result of extensive studies, the present inventors have found that the above object can be achieved by the means described below, and have arrived at the present invention.

Thus, the present invention includes the following aspect (1):
(1) A high-purity electrodeposited copper comprising copper and inevitable impurities, wherein the high-purity electrodeposited copper has:
   a purity of 6N or more;
   an amount of Ag contained as an impurity of 0.2 ppm or less;
   a number of contained nonmetallic inclusions with a grain size of 0.5 um or more and 20 um or less of 20,000 or less per gram;
   an average grain size of an electrodeposition cross section in a range of 40 to 400 um;
   a maximum grain size of an electrodeposition cross section in a range of 300 to 2700 um;
   an average grain size on an electrodeposited surface in a range of 25 to 150 um; and
   a maximum grain size on an electrodeposited surface in a range of 100 to 450 um.

### [Advantageous Effects of Invention]

According to the present invention, it is possible to produce high-purity electrodeposited copper that suppresses the generation of lumps and at the same time has improved crushability. The high-purity electrodeposited copper has reduced strength and improved crushability, so that the subsequent crushing process is easy, and the risk of contamination with impurities during the crushing process is minimized. Therefore, the high-purity electrodeposited copper according to the present invention does not lose its excellent characteristics during the crushing process, and can be suitably used as a raw material for Cu-based targets.

### [Brief Description of Drawings]

[Fig. 1A]

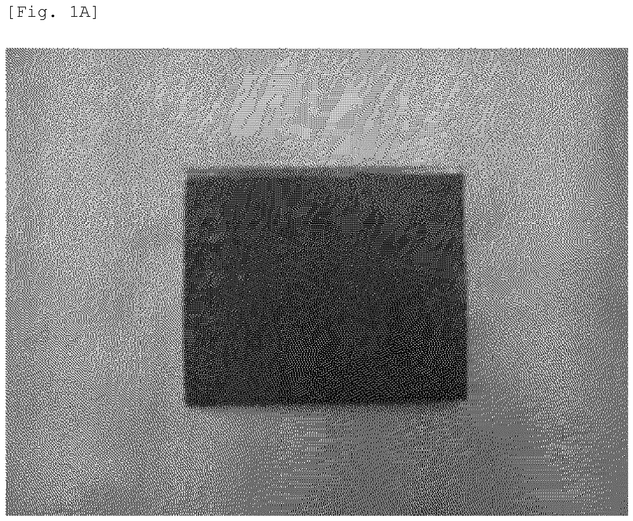

   Fig. 1A is an image of an appearance of a test piece obtained by cutting a part of an electrodeposited copper (sample 1) obtained in Example 1 into a 50 mm square piece.
[Fig. 1B]

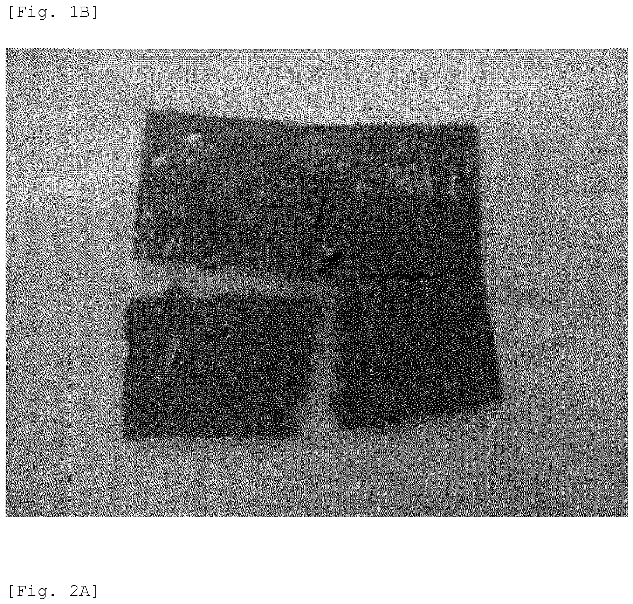

   Fig. 1B is an image of an appearance of a test piece of sample 1 crushed in a crushability test.
[Fig. 2A]

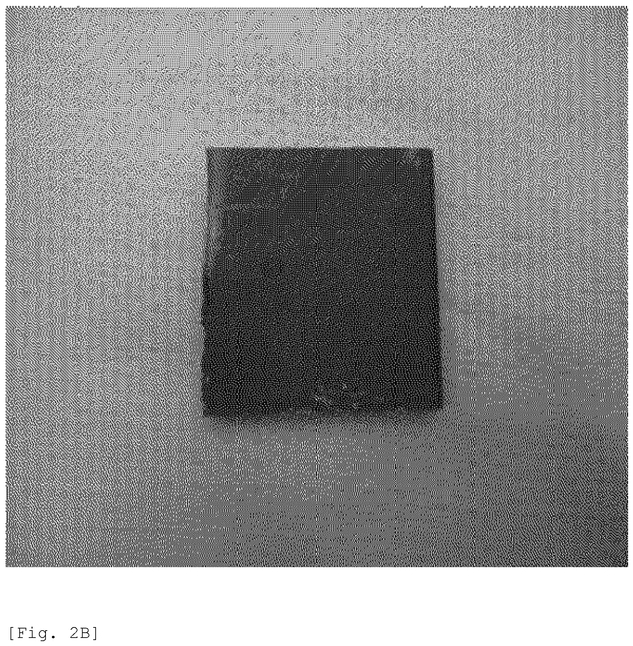

   Fig. 2A is an image of an appearance of a test piece obtained by cutting a part of an electrodeposited copper (sample 2) obtained in Comparative Example 1 into a 50 mm square piece.
[Fig. 2B]

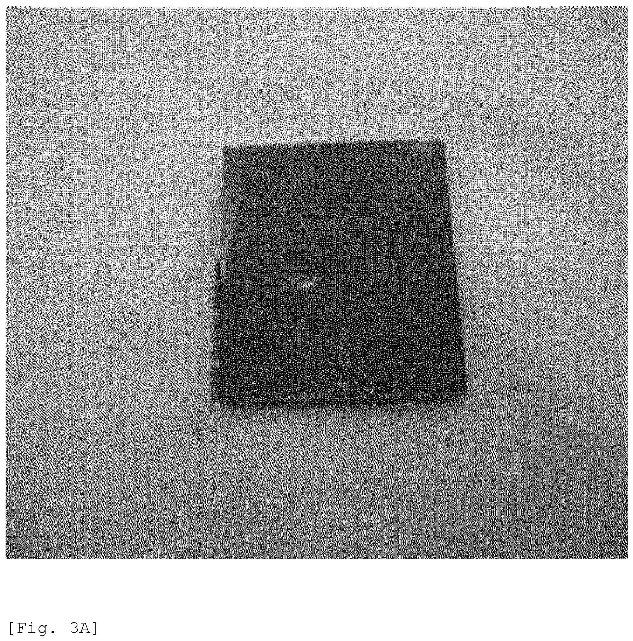

   Fig. 2B is an image of an appearance of a test piece of sample 2 that was not crushed by a crushability test.
[Fig. 3A]

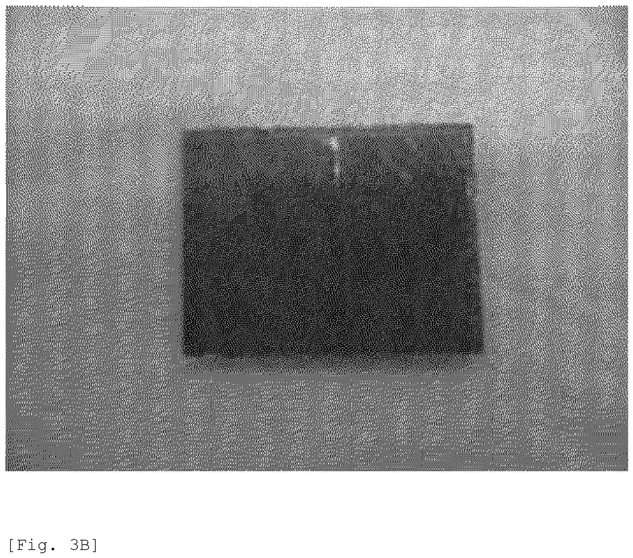

   Fig. 3A is an image of an appearance of a test piece obtained by cutting a part of an electrodeposited copper (sample 3) obtained in Comparative Example 2 into a 50 mm square piece.
[Fig. 3B]

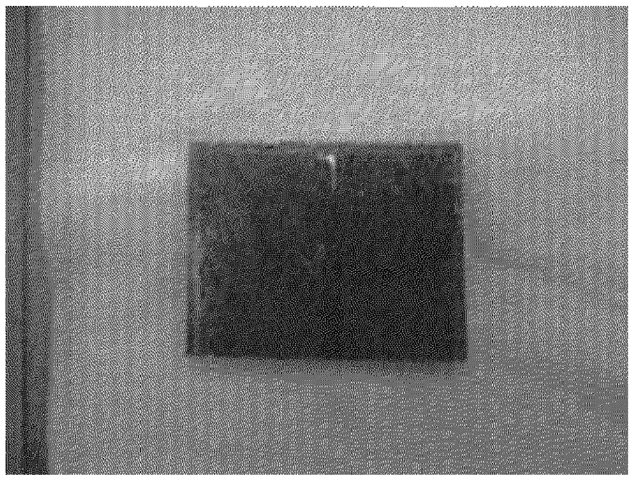

   Fig. 3B is an image of an appearance of a test piece of sample 3 that was not crushed by a crushability test.

### [Description of Embodiments]

The present invention will be described below in detail with reference to specific embodiments. The present invention is not limited to the specific embodiments disclosed below.

### [High-Purity Electrodeposited Copper]

The present invention provides a high-purity electrodeposited copper comprised of copper and inevitable impurities, wherein the high-purity electrodeposited copper has: a purity of 6N or more; an amount of Ag contained as an impurity of 0.2 ppm or less; a number of contained nonmetallic inclusions with a grain size of 0.5 um or more and 20 um or less of, for example, 20,000 or less per gram, preferably 15,000 or less per gram; an average grain size of an electrodeposition cross section in a range of 40 to 400 um; a maximum grain size of the electrodeposition cross section in a range of 300 to 2700 um; an average grain size on an electrodeposited surface in a range of 25 to 150 um; and a maximum grain size on the electrodeposited surface in a range of 100 to 450 um.

### [Purity]

In a preferred embodiment, the purity of the high-purity electrodeposited copper can be, for example, 6N (99.9999% by mass) or more. Although the upper limit of the purity of the high-purity electrodeposited copper is not particularly limited, it can be, for example, 7N (99.99999% by mass) or less.

### [impurities]

In a preferred embodiment, the following elements and contents (ppm by mass) may be mentioned as impurities contained in the high-purity electrodeposited copper.
Ag: for example, 0.2 ppm or less, preferably 0.1 ppm or less;
Br: for example, 0.1 ppm or less, preferably 0.05 ppm or less; and
Cl: for example, 1 ppm or less, preferably 0.5 ppm or less.

### [Nonmetallic Inclusions]

In a preferred embodiment, for the high-purity electrodeposited copper, the number of nonmetallic inclusions contained in the high-purity electrode deposited copper, which have a grain size of 0.5 um or more and 20 um or less, is, for example, 20,000 or less per gram, preferably 15,000 per gram. The nonmetallic inclusions as used herein refer to LPC detected by LPC measurement. The nonmetallic inclusions can be measured by the means as described below in the Example section. Although the lower limit of the contents of the nonmetallic inclusions is not particularly limited, for example, the number of the nonmetallic inclusions with a grain size of 0.5 um or more and 20 um or less is 50 or more per gram, or 100 or more per gram, or 500 or more per gram, or 1000 or more per gram.

### [Electrodeposition Cross Section]

In a preferred embodiment, the high-purity electrodeposited copper has an average grain size observed in its electrodeposition cross section, for example, in the range of 40 to 400 um, preferably in the range of 50 to 350 um, more preferably in the range of 80 to 300 um, even more preferably in the range of 100 to 250 um, particularly preferably in the range of 100 to 200 um, or preferably in the range of 80 to 400 um, even more preferably in the range of 100 to 400 um, still more preferably in the range of 100 to 300 um.

In a preferred embodiment, the high-purity electrodeposited copper has a maximum grain size observed in its electrodeposition cross section, for example, in the range of 300 to 2,700 um, preferably in the range of 450 to 2,500 um, more preferably in the range of 450 to 2,000 um, even more preferably in the range of 450 to 1,500 um, still more preferably in the range of 450 to 1,000 um, or in the range of 300 to 2,000 um, more preferably in the range of 300 to 1,500 um, even more preferably in the range of 300 to 1,000 um.

The term "electrodeposition cross section" refers to a cross section obtained by cutting copper electrodeposited on a cathode plate along a plane parallel to a normal direction on a surface of the cathode plate. The average grain size and the maximum grain size in the electrodeposition cross section can be measured by the means as described below in the Example section.

### [Electrodeposited Surface]

In a preferred embodiment, the high-purity electrodeposited copper has an average grain size observed on its electrodeposited surface, for example, in the range of 25 to 150 um, preferably in the range of 50 to 130 um, more preferably in the range of 65 to 115 um, particularly preferably in the range of 75 to 100 um.

In a preferred embodiment, the high-purity electrodeposited copper has a maximum grain size observed on its electrodeposited surface, for example, in the range of 100 to 450 um, preferably in the range of 150 to 350 um, particularly preferably in the range of 200 to 300 um, or preferably in the range of 150 to 450 um, more preferably in the range of 200 to 450 um, particularly preferably in the range of 250 to 400 um.

The electrodeposited surface refers to a surface where the copper electrodeposited on the cathode plate was in contact with the cathode plate. The electrodeposited surface can be observed by peeling off the electrodeposited copper from the cathode plate. The average grain size and the maximum grain size on the electrodeposited surface can be measured by the means as described below in the Example section.

### [Crushability]

In a preferred embodiment, the high-purity electrodeposited copper according the present invention has improved crushability. The high-purity electrodeposited copper according to the present invention has reduced strength and improved crushability, so that the subsequent crushing process is easy, and the risk of contamination with impurities during the crushing process is minimized. Therefore, the high-purity electrodeposited copper according to the present invention does not lose its excellent characteristics during the crushing process, and can be suitably used as a raw material for Cu-based targets. The crushability can be confirmed by the test as described below in the Example section.

### [Preferable Embodiment of Present Invention]

As preferable embodiments, the present invention includes the following aspects (1) to (6):
(1) A high-purity electrodeposited copper comprising copper and inevitable impurities, wherein the high-purity electrodeposited copper has:
   a purity of 6N or more;
   an amount of Ag contained as an impurity of 0.2 ppm or less;
   a number of contained nonmetallic inclusions with a grain size of 0.5 um or more and 20 um or less of 20,000 or less per gram;
   an average grain size of an electrodeposition cross section in a range of 40 to 400 um;
   a maximum grain size of an electrodeposition cross section in a range of 300 to 2700 um;
   an average grain size on an electrodeposited surface in a range of 25 to 150 um; and
   a maximum grain size on an electrodeposited surface in a range of 100 to 450 um.
(2) The high-purity electrodeposited copper according to (1), wherein the average grain size of the electrodeposition cross section is in a range of 50 to 350 um, and the maximum grain size of the electrodeposition cross section is in a range of 450 to 2,500 um.
(3) The high-purity electrodeposited copper according to (1) or (2), wherein the average grain size on the electrodeposited surface is in a range of 65 to 115 um, and the maximum grain size on the electrodeposited surface is in a range of 150 to 350 um.
(4) The high-purity electrodeposited copper according to any one of (1) to (3), wherein the elements contained as impurities are 0.1 ppm or less of Ag, 0.05 ppm or less of Br, and 5 ppm or less of Cl.
(5) The high-purity electrodeposited copper according to any one of (1) to (4), wherein the number of the contained nonmetallic inclusions with a grain size of 0.5 um or more and 20 um or less is 15,000 or less per gram.
(6) The high-purity electrodeposited copper according to any one of (1) to (5), wherein the high-purity electrodeposited copper is highly crushable high-purity electrodeposited copper.

### [Examples]

The present invention will be described below in detail by providing Examples. The present invention is not limited to the Examples illustrated below.

### [Example 1]

### [Production of Electrodeposited Copper]

High-purity electrodeposited copper was produced by electrolysis using an electrolytic bath under the following conditions:
Cathode: Ti plate;
Anode: 4N electrolytic copper;
Distance between cathode and anode: 40-60 mm;
Electrolyte composition: copper nitrate solution;
HBr (additive) in electrolyte: HBr was added so that a Br concentration was 1 to 10 mg/L;
Cu concentration in electrolyte: 50-100 g/liter;
Temperature of electrolyte: 15-35 °C;
pH of electrolyte: 0.8 to 1.8:
   Current density: 0.5-1.5 A/dm²; and
   Electrolysis time: 240 hours.

Table 1 shows the types of additives added to the electrolyte and the contents of the components of the electrolyte at the start in Example 1. PVA is polyvinyl alcohol.

**[Table 1]**

| | Addieives | Contents in Electrolyte | | | | | Rate of Addition |
|---|---|---|---|---|---|---|---|
| | | Cu | Ag | Cl | Br | PVA | PVA |
| | | g/L | mg/L | mg/L | mg/L | mg/kg | mg/L•h |
| Ex. 1 | HBr | 72.0 | 0.008 | 10 | 2 | - | - |
| Comp. 1 | PVA + HCl | 72.6 | 0.004 | 36 | - | 3.2 | 0.06 |
| Comp. 2 | PVA + HBr | 58.4 | 0.003 | 21 | 8 | Not Detected | 0.05 |

### [Evaluation of Electrodeposited Copper]

### [Grade of Electrodeposited Copper]

Although the electrodeposited copper according to Example 1 showed the generation of bumps in the normal level, no abnormally grown bumps that would cause a short circuit were observed. That is, the generation of bumps was suppressed to a sufficient extent during the production steps.

A part of the electrodeposited copper (sample 1) obtained in Example 1 was collected, and the contained components were analyzed by GDMS (Glow Discharge Mass Spectrometry). The results obtained are shown in Tables 2-1 and 2-2. Unless otherwise specified, each content is expressed in ppm by mass. Values written with inequality signs indicate that they were less than the respective measurement limit values. The electrodeposit produced in Example 1 was found to have a purity of 6N (99.9999% by mass) as measured by GDMS. The fifteen components measured by GDMS are shown below.

**[Table 2-1]**

| | Na | Al | Si | S | C1 | Ca | Fe | Ni |
|---|---|---|---|---|---|---|---|---|
| Ex. 1 | <0.005 | 0.001 | <0.005 | 0.025 | 0.2 | <0.005 | <0.001 | <0.001 |
| Com. 1 | <0.005 | <0.001 | 0.004 | <0.005 | 5.3 | <0.005 | <0.001 | <0.001 |
| Com. 2 | <0.005 | <0.001 | <0.005 | 0.003 | 11.3 | <0.005 | <0.001 | <0.001 |

**[Table 2-2]**

| | As | Br | Ag | Sn | Sb | Pb | Bi |
|---|---|---|---|---|---|---|---|
| Ex. 1 | <0.005 | <0.05 | 0.09 | <0.01 | <0.002 | <0.002 | <0.001 |
| Com. 1 | <0.005 | <0.05 | 0.08 | <0.01 | <0.002 | <0.002 | <0.001 |
| Com. 2 | <0.005 | <0.05 | 0.04 | <0.01 | <0.002 | <0.002 | <0.001 |

### [Crystal Grain Size of Electrodeposited Copper]

The electrodeposited copper (sample 1) obtained in Example 1 was cut into 10 to 20 mm square pieces, and the electrodeposited surface and the cross section were wet-polished to #1000, and then electrolytically polished and etched with an electrolytic polishing device (Struers/LECTROPOL-5).

After electrolytic polishing and etching, microstructure photographs of the electrodeposited surface and the cross section were taken using an optical microscope (Nikon/ECRIPSE MA200), and crystal grain size evaluation was performed using analysis software (Nikon/NIS-Elements) according to ASTM E 112-96 in the ASTM standard. The observation magnifications for Example 1 were 50 times. In Comparative Examples 1 and 2, the observation magnifications were 400 times in view of measurement accuracy, because the observed crystal grains were smaller. Table 3 shows the results of the crystal grain size evaluation. The average grain size refers to an average value of the grain sizes in the field of view in which the microstructure photograph was taken, and the maximum grain size refers to the maximum value of the grain sizes measured in the field of view in which the microstructure photograph was taken. The sample for microstructural observation was cut out from the vicinity of the center of the electrodeposit, and observation was performed in a field of view of 2502.6 um × 1779.6 um at observation magnifications of 50 and in field of view of 314.2 µm × 223.4 um at observation magnifications of 400 at two positions randomly selected in one sample for each of the electrodeposited surface and the electrodeposition cross section to measure the grain sizes. For the electrodeposition cross section, in order to observe the entire growth direction of the electrodeposits growing from the electrodeposited surface, two measurement positions were selected near the center of the electrodeposit in the electrodeposition cross section, and the grain size measurements were carried out for each of images taken by dividing the total length from the electrodeposited surface to the tip of the electrodeposit in the growth direction at each measurement position into the field of view of 2502.6 um × 1779.6 um at observation magnifications of 50 and the field of view of 314.2 µm × 223.4 um at observation magnifications of 400. At the observation magnifications of 50, the number of divided fields of view was 2 to 5, so the grain size measurements were carried out for all of those fields of view. At the observation magnifications of 400, the number of divided fields of view was several dozen, so two fields of view were extracted for each measurement position, and the grain sizes were measured for those fields of view. The fields of view were extracted by dividing the region between the electrodeposited surface and the tip of the electrodeposition growth into an upper half part and a lower half part in the electrodeposition growth direction for each measurement position, and one representative field of view was extracted at a position that was not too close to the half line from the upper half part so as to avoid the vicinity of the tip of the electrodeposition growth, and one representative field of view was extracted at a position that was not too close to the half line from the lower half part so as to avoid the vicinity of the cathode plate, thereby extracting the two fields of view at each measurement position.

**[Table 3]**

| | Maximum Point Stress (Mpa) | Average Grain Size (µm) | | Maximum Grain Size (µm) | | LPC (number/g) |
|---|---|---|---|---|---|---|
| | Bending Test | Electrodeposition Cross Section | Electrodeposited Surface | Electrodeposition Cross Section | Electrodeposited Surface | |
| Ex. 1 | 88.4 | 145.2 | 92.3 | 455.2 | 280.3 | 14520 |
| Comp. 1 | 266.6 | 28.6 | 17.5 | 141.5 | 72.4 | 3910 |
| Comp. 2 | 319.7 | 21.8 | 22.4 | 72.5 | 135.3 | 34950 |

### [LPC Analysis of Electrodeposited Copper]

The electrodeposited copper (sample 1) obtained in Example 1 was subjected to LPC (Liquid Particle Counter) analysis according to the following procedure:
5 g of electrodeposited copper was sampled, and slowly dissolved in 210 cc of an acid such that inclusions were not dissolved, and further diluted with pure water to 500 cc, and 10 cc of it was collected and measured with a liquid particle sensor KS-42C (Kyushu Rion Co., Ltd.) in accordance with JIS B 9925.

The results of the LPC analysis are shown in Table 3. This LPC analysis is an analysis in which nonmetallic grains with a grain size of 0.5 um or more and 20 um or less are measured due to the specifications of the device.

### [Bending Test for Electrodeposited Copper]

A bending test was conducted on the electrodeposited copper (sample 1) obtained in Example 1 according to the following procedure:
The electrodeposited copper was cut into 3 × 4 × 35 mm and wet-polished to #200. The prepared sample was subjected to a bending test using a uniaxial testing machine (A&D Company, Limited) STB-1225S. The test conditions are as follows:
Operation mode: single operation;
Operation direction: Down;
Deformation mode: 3-point bending test;
Speed mode: constant control of movement speed;
Moving speed: 0.5 mm/min;
Target load: 5 N;
Creep speed: 10 mm/min; and
Holding time: 3s.

The results of the bending test are shown in Table 3.

### [Crushability of Electrodeposited Copper]

A part of the electrodeposited copper (sample 1) obtained in Example 1 was cut into a 20 mm square test piece, which was subjected to the crushability test.

The crushability test was conducted by putting a chisel near the center of the test piece and repeatedly striking it by a hammer with a constant force to observe whether the test piece would be crushed.

When the test piece made of the electrodeposited copper according to Example 1 (sample 1) was struck about 10 times, a crack developed from the position against which the chisel was put, and it could be broken.

Fig. 1A shows an image of an appearance of the test piece obtained by cutting a part of the electrodeposited copper (sample 1) obtained in Example 1 into the 20 mm square piece. Fig. 1B shows an image of an appearance of the test piece of sample 1 that was crushed in the crushability test.

### [Comparative Example 1]

### [Production of Electrodeposited Copper]

High-purity electrodeposited copper according to Comparative Example 1 was produced by performing electrodeposition in the same manner as that of Example 1, with the exception that the conditions were changed to those shown below:
Electrolyte composition: copper nitrate solution;
HCl (additive): HCl was added so that the Cl concentration was 20 to 40 mg/L;
PVA (additive): PVA was added so that the PVA concentration was 0.5 to 1.5 mg/L; and
Current density: 1.4-2.0 A/dm².

Table 1 shows the types of additives added to the electrolyte and the contents of the electrolyte components at the start and at the end of Comparative Example 1.

### [Evaluation of Electrodeposited Copper]

To evaluate the grade of the electrodeposited copper, a part of the electrodeposited copper (sample 2) obtained in Comparative Example 1 was collected, and the contained components were analyzed by GDMS in the same manner as that of Example 1. The results obtained are shown in Tables 2-1 and 2-2. The electrodeposited copper produced in Comparative Example 1 had a purity of 5N.

For the crystal grain size of the electrodeposited copper, the electrodeposited copper (sample 2) obtained in Comparative Example 1 was evaluated in the same manner as that of Example 1. Table 3 shows the results of the crystal grain size evaluation.

LPC analysis and bending test of the electrodeposited copper were performed on the electrodeposited copper (sample 2) obtained in Comparative Example 1 in the same manner as that of Example 1. The evaluation results are shown in Table 3.

The crushability of the electrodeposited copper was evaluated in the same manner as that of Example 1 for the electrodeposited copper (sample 2) obtained in Comparative Example 1.

The test piece made of the electrodeposited copper (sample 2) according to Comparative Example 1 left dents after being struck 20 times, but it could not be broken.

Fig. 2A shows an image of an appearance of the test piece obtained by cutting a part of the electrodeposited copper (sample 2) obtained in Comparative Example 1 into a 20 mm square piece. Fig. 2B shows an image of an appearance of the test piece of sample 2 that was not crushed by the crushability test.

### [Comparative Example 2]

### [Production of Electrodeposited Copper]

High-purity electrodeposited copper according to Comparative Example 2 was produced by performing electrodeposition in the same manner as that of Example 1, with the exception that the conditions were changed to those shown below:
Electrolyte composition: copper nitrate solution;
HBr (additive): HBr was added so that the Br concentration was 10-10 mg/L;
PVA (additive): PVA was added so that the PVA concentration was 0.5-1.5 mg/L; and
Current density: 1.4-2.0 A/dm².

Table 1 shows the types of additives added to the electrolyte and the contents of the electrolyte components at the start and at the end of Comparative Example 2.

### [Evaluation of Electrodeposited Copper]

To evaluate the grade of the electrodeposited copper, a part of the electrodeposited copper (sample 3) obtained in Comparative Example 2 was collected, and the contained components were analyzed by GDMS in the same manner as that of Example 1. The results obtained are shown in Tables 2-1 and 2-2. The electrodeposited copper produced in Comparative Example 2 had a purity of 4N.

For the crystal grain size of the electrodeposited copper, the electrodeposited copper (sample 3) obtained in Comparative Example 2 was evaluated in the same manner as that of Example 1. Table 3 shows the results of the crystal grain size evaluation.

LPC analysis, bending test and tensile test of the electrodeposited copper were performed on the electrodeposited copper (sample 3) obtained in Comparative Example 2 in the same manner as that of Example 1. The evaluation results are shown in Table 3.

The crushability of the electrodeposited copper was evaluated in the same manner as that of Example 1 for the electrodeposited copper (sample 3) obtained in Comparative Example 2.

The test piece made of the electrodeposited copper (sample 3) according to Comparative Example 2 left dents after being struck 20 times, but it could not be broken.

Fig. 3A shows an image of an appearance of the test piece obtained by cutting a part of the electrodeposited copper (sample 3) obtained in Comparative Example 2 into a 20 mm square piece. Fig. 3B shows an image of an appearance of the test piece of sample 3 that was not crushed by the crushability test.

### [Regarding Evaluation Results]

In the electrodeposited copper obtained in Example 1, the generation of lumps was suppressed to such an extent that it did not interfere with long-term electrolysis, even though no PVA was added during production by electrolysis. The electrodeposited copper obtained in Example 1 had improved crushability and could be crushed by a simple operation using an easy-to-clean instrument. As a result, the electrodeposited copper obtained in Example 1 did not require any cutting operation with a cutting tool prior to operations such as placing it in a crucible to form the electrodeposited copper into an ingot. That is, in principle, the electrodeposited copper obtained in Example 1 could avoid any possibility to be contaminated with other metal elements which would otherwise be contaminated by the cutting operation with the cutting tool in many cases.

In the electrodeposited copper obtained in each of Comparative Examples 1 and 2, the generation of lumps was suppressed to such an extent that it did not interfere with long-term electrolysis, even though no PVA was added during production by electrolysis. However, the electrodeposited copper obtained in each of Comparative Examples 1 and 2 had poor crushability and could not be crushed by a simple operation using an easy-to-clean instrument. Therefore, the electrodeposited copper obtained in each of Comparative Examples 1 and 2 required the cutting operation with a cutting tool prior to operations such as placing it in a crucible to form the electrodeposited copper into an ingot. That is, the electrodeposited copper obtained in each of Comparative Examples 1 and 2 could not avoid any possibility to be contaminated with other metal elements which would otherwise be contaminated by the cutting operation with the cutting tool in many cases.

The reason why the electrodeposited copper obtained by the present invention is an electrodeposited copper with lower strength and improved crushability, although it has the high purity and less inclusions while suppressing the generation of large lumps is unknown. However, the present inventors believe that it can be achieved by adjusting the electrolytic conditions while adding halide acid to the electrolyte to control the crystal grains in the electrodeposition cross section to the predetermined grain size range, and at the same time, by controlling the crystal grains on the electrodeposited surface to the predetermined grain size range. In other words, the present inventors believe that when the organic additive such as PVA is added, the resulting microstructure of the deposited copper becomes finer, thereby effectively suppressing the formation of lumps, while deteriorating the crushability. The present inventors also believe that, in order to achieve good crushability and sufficient suppression of lump formation, it is particularly important to control the average grain size and the maximum grain size of the crystal grains to the specific ranges on both the electrodeposition cross section and the electrodeposited surface.

### [Industrial Applicability]

The present invention provides high-purity electrodeposited copper that suppresses the formation of lumps and has improved crushability. The present invention is an industrially useful invention.

## Claims

1. A high-purity electrodeposited copper comprising copper and inevitable impurities, wherein the high-purity electrodeposited copper has:
a purity of 6N or more;
an amount of Ag contained as an impurity of 0.2 ppm or less;
a number of contained nonmetallic inclusions with a grain size of 0.5 um or more and 20 um or less of 20,000 or less per gram;
an average grain size of an electrodeposition cross section in a range of 40 to 400 um;
a maximum grain size of an electrodeposition cross section in a range of 300 to 2700 um;
an average grain size on an electrodeposited surface in a range of 25 to 150 um; and
a maximum grain size on an electrodeposited surface in a range of 100 to 450 um.

2. The high-purity electrodeposited copper according to claim 1, wherein the average grain size of the electrodeposition cross section is in a range of 50 to 350 um, and the maximum grain size of the electrodeposition cross section is in a range of 450 to 2500 um.

3. The high-purity electrodeposited copper according to claim 1, wherein the average grain size on the electrodeposited surface is in a range of 65 to 115 um, and the maximum grain size on the electrodeposited surface is in a range of 150 to 350 um.

4. The high-purity electrodeposited copper according to claim 1, wherein the elements contained as impurities are 0.1 ppm or less of Ag, 0.05 ppm or less of Br, and 5 ppm or less of Cl.

5. The high-purity electrodeposited copper according to claim 1, wherein the number of the contained nonmetallic inclusions with a grain size of 0.5 um or more and 20 um or less is 15,000 or less per gram.

6. The high-purity electrodeposited copper according to any one of claims 1 to 5, wherein the high-purity electrodeposited copper is highly crushable high-purity electrodeposited copper.
